(19) Europäisches Patentamt
European Patent Office
Office européen des brevets

(11) **EP 3 276 124 B1**

(12) **FASCICULE DE BREVET EUROPEEN**

(45) Date de publication et mention
de la délivrance du brevet:
**18.03.2020 Bulletin 2020/12**

(51) Int Cl.:
*E21B 41/00* (2006.01)   *E21B 43/16* (2006.01)

(21) Numéro de dépôt: **17305816.5**

(22) Date de dépôt: **29.06.2017**

(54) **PROCEDE D'EXPLOITATION D'UN GISEMENT D'HYDROCARBURES PAR INJECTION D'UN GAZ SOUS FORME DE MOUSSE**

VERFAHREN ZUM ABBAU EINES KOHLENWASSERSTOFFLAGERS DURCH EINSPRITZUNG VON SCHAUMFÖRMIGEM GAS

METHOD FOR OPERATING A HYDROCARBON RESERVOIR BY INJECTING A GAS IN FOAM FORM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.07.2016 FR 1657393**

(43) Date de publication de la demande:
**31.01.2018 Bulletin 2018/05**

(73) Titulaire: **IFP Energies nouvelles
92500 Rueil-Malmaison (FR)**

(72) Inventeurs:
• BOURBIAUX, Bernard
  92500 RUEIL MALMAISON (FR)
• PREUX, Christophe
  78260 ACHERES (FR)
• NABZAR, LAHCEN
  92500 RUEIL MALMAISON (FR)
• BRACONNIER, Benjamin
  92160 ANTONY (FR)

(74) Mandataire: **IFP Energies nouvelles
Département Propriété Industrielle
Rond Point de l'échangeur de Solaize
BP3
69360 Solaize (FR)**

(56) Documents cités:
• YONGCHAO ZENG ET AL: "Insights on Foam Transport from a Texture-Implicit Local-Equilibrium Model with an Improved Parameter Estimation Algorithm", INDUSTRIAL & ENGINEERING CHEMISTRY RESEARCH., vol. 55, no. 28, 20 juillet 2016 (2016-07-20), pages 7819-7829, XP055372352, US ISSN: 0888-5885, DOI: 10.1021/acs.iecr.6b01424
• Energy & Fuels ET AL: "Estimation of parameters for the simulation of foam flow through porous media: Part 1; the dry-out effect ACS Paragon Plus Environment Estimation of parameters for the simulation of foam flow through porous media: Part 1; the dry-out effect", , 3 mai 2013 (2013-05-03), XP055372411, Extrait de l'Internet: URL:http://pubs.acs.org/doi/abs/10.1021/ef 302036s [extrait le 2017-05-12]
• Robert Heins ET AL: "Modelling the effect of oil on foam with the wave curve method", Prof. Dr. W. R. Rossen Co-advisor: Dr. D. Marchesin Thesis committee, 1 janvier 2015 (2015-01-01), XP055372436, Extrait de l'Internet: URL:http://repository.tudelft.nl/islandora /object/uuid:29edf411-cf49-4ab3-a704-117d7 459dd83/datastream/OBJ/download [extrait le 2017-05-12]

**Description**

La présente invention concerne le domaine de l'exploitation d'un fluide contenu dans une formation souterraine, plus particulièrement la récupération assistée d'un fluide, tel qu'un fluide hydrocarboné, par injection de mousse.

L'exploitation d'un réservoir pétrolier par récupération primaire consiste à extraire, via un puits dit de production, le pétrole présent du réservoir par l'effet de surpression régnant naturellement au sein du réservoir. Cette récupération primaire ne permet d'accéder qu'à une faible quantité du pétrole contenu dans le réservoir, de l'ordre de 10 à 15% tout au plus.

Pour permettre de poursuivre l'extraction du pétrole, des méthodes secondaires de production sont employées, quand la pression du réservoir devient insuffisante pour déplacer le pétrole encore en place. Notamment, on injecte un fluide (ré-injection de l'eau produite diluée ou non, injection d'eau de mer ou de rivière, ou encore injection de gaz, par exemple) au sein du réservoir hydrocarboné, en vue d'exercer au sein du réservoir une surpression propre à entraîner le pétrole vers le ou les puits de production. Une technique usuelle dans ce cadre est l'injection d'eau (désignée également par le terme anglais « waterflooding »), dans laquelle de grands volumes d'eau sont injectés sous pression dans le réservoir via des puits injecteurs. L'eau injectée entraîne une partie du pétrole qu'elle rencontre et le pousse vers un ou plusieurs puits producteurs. Les méthodes secondaires de production telles que l'injection d'eau ne permettent toutefois d'extraire qu'une partie relativement faible des hydrocarbures en place (typiquement de l'ordre de 30%). Ce balayage partiel est dû notamment au piégeage de l'huile par les forces capillaires, aux différences de viscosité et de densité existant entre le fluide injecté et les hydrocarbures en place, ainsi qu'à des hétérogénéités à des échelles micro- ou macroscopiques (échelle des pores et aussi échelle du réservoir).

Pour essayer de récupérer le reste du pétrole, qui demeure dans les formations souterraines à l'issue de la mise en œuvre des méthodes primaires et secondaires de production, il existe différentes techniques dites de récupération assistée (connue sous l'acronyme « EOR », correspondant à « *Enhanced Oil Recovery* »). Parmi ces techniques, on peut citer des techniques s'apparentant à l'injection d'eau précitée, mais employant une eau comprenant des additifs tels que, par exemple, des agents tensioactifs solubles dans l'eau (on parle alors de « *surfactant flooding* »). L'emploi de tels agents tensioactifs induit notamment une diminution de la tension interfaciale eau/pétrole, ce qui est propre à assurer un entraînement plus efficace du pétrole piégé au niveau des constrictions de pores.

On connaît également la récupération assistée par injection de gaz, miscibles ou non (gaz naturel, azote ou $CO_2$). Cette technique permet de maintenir la pression dans le réservoir pétrolier au cours de son exploitation, mais peut aussi permettre, dans le cas de gaz miscibles, de mobiliser les hydrocarbures en place et ainsi d'en améliorer le débit. Un gaz couramment utilisé est le dioxyde de carbone lorsqu'il est disponible à bas coût.

On connaît aussi des techniques alternatives reposant sur une injection de mousse dans le réservoir pétrolier. En raison de sa viscosité apparente élevée, la mousse est considérée comme une alternative au gaz comme fluide d'injection dans les réservoirs d'hydrocarbures. La mobilité de la mousse est ainsi réduite par rapport au gaz qui, lui, a tendance à ségréger et à percer rapidement aux puits producteurs, notamment dans les réservoirs hétérogènes et/ou épais. La récupération assistée par injection de mousse est particulièrement attractive car elle requiert l'injection de volumes moindres que pour d'autres procédés de récupération assistée à base de fluides non moussants.

**Etat de la technique**

Les documents suivants seront cités dans la suite de la description :

Ma, K., Lopez-Salinas, J.L., Puerto, M.C., Miller, C.A., Biswal, S.L., Hirasaki, G.J., 2013. Estimation of Parameters for the Simulation of Foam Flow through Porous Media. Part 1: The Dry-Out Effect. Energy & Fuels 27, 2363-2375 (ACS Publications).

Farajzadeh, R., Lotfollahi, M., Eftekhari, A.A., Rossen, W.R. and Hirasaki, G.J., 2015. Effect of Permeability on Implicit-Texture Foam Model Parameters and the Limiting Capillary Pressure. Energy Fuels 29, 3011-3018 (ACS Publications).

Kapetas, L., Vincent-Bonnieu, S., Farajzadeh, R., Eftekhari, A.A., Mohd-Shafian, S.R., Kamarul Bahrim, R.Z. and Rossen, W.R., 2015. Effect of Permeability on Foam-Model Parameters - An Integrated Approach from Coreflood Experiments through to Foam Diversion Calculations. 18th European Symposium on IOR, Dresden, 14-16 April.

L'exploitation pétrolière d'un gisement consiste à sélectionner les zones du gisement présentant le meilleur potentiel pétrolier, à définir des schémas d'exploitation optimaux pour ces zones (à l'aide notamment d'une simulation numérique des écoulements dans le gisement, afin de définir le type de récupération, les nombre et positions des puits d'exploitation permettant une récupération d'hydrocarbures optimale), à forer des puits d'exploitation et, de façon générale, à mettre en place les infrastructures de production nécessaires au développement du gisement.

La définition d'un schéma d'exploitation d'un réservoir pétrolier comprenant une étape de récupération assistée par injection de mousse peut nécessiter de simuler numériquement, de la façon la plus réaliste possible, les écoulements en présence de mousse dans le réservoir considéré. Une telle simulation est réalisée à l'aide d'un simulateur d'écoulement comprenant un modèle de déplacement de la mousse.

Un tel modèle peut nécessiter d'évaluer les performances de la mousse en termes de réduction de mobilité. En général, cette estimation passe par la réalisation d'expériences de laboratoire consistant à mesurer les pertes de charge lors de déplacements de mousse d'une part, d'eau et de gaz non moussant d'autre part dans un échantillon du réservoir pétrolier. Puis ce modèle de déplacement de la mousse, représentatif des écoulements à l'échelle du laboratoire, est calibré à l'échelle du réservoir avant de réaliser les simulations numériques des écoulements, afin de prédire le bénéfice procuré par l'injection de la mousse en termes d'amélioration de l'efficacité de déplacement des fluides en place.

Les modèles de déplacement de la mousse utilisés par l'industrie sont des modèles relativement simples qui, sous les conditions d'existence de la mousse, simulent uniquement les effets de la mousse en termes de réduction de mobilité et non les processus de génération-destruction de la mousse. De façon générale, les modèles de déplacement de la mousse dépendent non linéairement de nombreux paramètres (constantes de calibration). La détermination des paramètres de ce modèle passe donc par la résolution d'un problème inverse non linéaire. Toutefois, la complexité du déplacement d'une mousse dans un milieu confiné que constitue tout milieu poreux naturel rend la modélisation difficile car le grand nombre de paramètres influençant la mousse peut conduire à des indéterminations (solutions multiples).

On connaît l'approche proposée dans le document (Ma et al., 2013) qui consiste à déterminer simultanément certains paramètres du modèle de déplacement de la mousse par une approche graphique, complétée par un ajustement numérique.

On connaît également la technique proposée dans le document (Farajzadeh et al. 2015) qui procède à la détermination des paramètres inconnus (constantes de calibration) du modèle de déplacement de la mousse par une approche des moindres carrés itérative. Toutefois, le problème posé étant non linéaire vis-à-vis de ces inconnues, il y a non unicité de la solution, ou autrement dit, les paramètres ainsi déterminés sont une solution parmi d'autres possibles (cf. par exemple Kapetas et al., 2015).

On connait également le document :
Zeng, Yongchao, Muthuswamy, Aarthi, Ma, Kun, et al.. "Insights on Foam Transport from a Texture-Implicit Local-Equilibrium Model with an Improved Parameter Estimation Algorithm." Industrial & Engineering Chemistry Research, 55, no. 28 (2016) 7819-7829. http://dx.doi.org/10.1021/acs.iecr.6b01424, qui concerne la calibration d'un modèle de déplacement de la mousse.

Le procédé selon l'invention vise à déterminer de façon pragmatique les paramètres du modèle de déplacement de la mousse. Au contraire des procédés existants, le procédé selon l'invention consiste, à partir des données expérimentales, en un ajustement séquentiel des paramètres du modèle de mousse, et non pas en un ajustement global. Ainsi, le procédé selon l'invention permet de minimiser les ajustements numériques, en essayant d'extraire le maximum d'informations sur le comportement dynamique de la mousse à partir des données expérimentales.

### Le procédé selon l'invention

Ainsi, la présente invention concerne un procédé d'exploitation d'une formation souterraine comportant des hydrocarbures, selon la revendication 1. Les revendications dépendantes 2-5 représentent des modes de réalisation de l'invention.

D'autres caractéristiques et avantages du procédé selon l'invention, apparaîtront à la lecture de la description ci-après d'exemples non limitatifs de réalisations, en se référant à la Figure annexée et décrite ci-après.

### Présentation succincte des figures

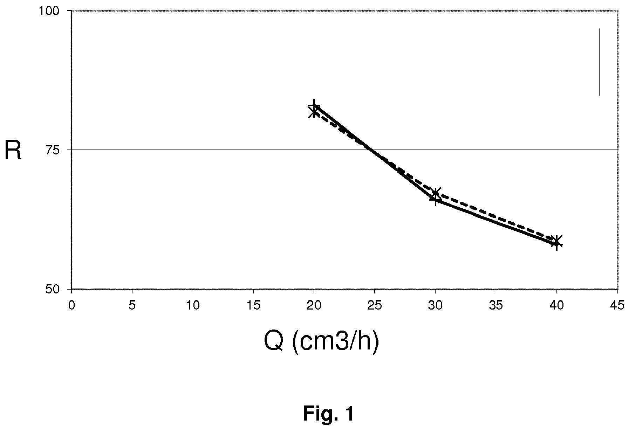

La Figure 1 présente un exemple d'évolution du facteur de réduction de mobilité R en fonction du débit de gaz Q.

### Description détaillée du procédé

De façon générale, l'un des objets de l'invention concerne un procédé d'exploitation d'une formation souterraine comportant des hydrocarbures, au moyen d'une injection d'une solution aqueuse comprenant un gaz sous forme de mousse, et notamment la détermination d'un schéma d'exploitation optimal de la formation souterraine étudiée. En particulier, le procédé selon l'invention vise à la détermination des paramètres d'un modèle de déplacement du gaz sous forme de mousse. Dans la suite, on appelle mousse une phase dispersée dans une autre phase par l'adjonction d'un agent moussant dans une des deux phases. L'une des phases peut être de l'eau et l'autre phase est un gaz, tel que du gaz naturel, de l'azote ou du $CO_2$.

Le procédé selon l'invention requiert de disposer :

- un échantillon de la formation souterraine étudiée, prélevé par carottage in situ par exemple ;

- un simulateur d'écoulement reposant sur un modèle de déplacement du gaz sous forme de mousse (cf ci-dessous) ;

- de mesures de perméabilités relatives conventionnelles au gaz sous forme non moussante et de mesures de perméabilités relatives conventionnelles à la phase aqueuse : il peut s'agir de mesures réalisées expressément pour le besoin du procédé selon l'invention (le spécialiste a parfaite connaissance de la manière de conduire de telles expériences de laboratoire), mais il peut également s'agir de fonctions analytiques calibrées à partir de corrélations bien connues du spécialiste.

Ainsi, le procédé selon l'invention requiert de disposer d'un simulateur d'écoulement comportant un modèle de déplacement de la mousse. Selon l'invention, le modèle de déplacement de la mousse repose sur l'hypothèse que le gaz présent sous forme de mousse voit sa mobilité réduite d'un facteur donné dans des conditions fixées de formation et d'écoulement de la mousse. La formulation d'un tel modèle, utilisée par de nombreux simulateurs d'écoulement, consiste en une modification des perméabilités relatives au gaz lorsque le gaz est présent sous forme de mousse, ce qui, pour une saturation en gaz $S_g$ donnée, s'exprime selon une formule du type :

$$k_{rg}^{FO}(S_g) = FM\, k_{rg}(S_g) \qquad\qquad (1)$$

où $k_{rg}^{FO}(S_g)$ est la perméabilité relative au gaz sous forme de mousse, qu'on exprime comme le produit d'une fonction $FM$ par la perméabilité relative au gaz non moussant $k_{rg}(S_g)$ pour la même valeur de saturation en gaz $S_g$ (notée plus loin $S_g^{FO}$). Une hypothèse sous-jacente aux modèles de mousse actuels est que la perméabilité relative à l'eau (ou au liquide par extension) est supposée inchangée, que le gaz soit présent sous forme de phase continue ou sous forme de mousse. Dans cette hypothèse, la fonctionnelle de réduction de mobilité du gaz, notée $FM$ par la suite, s'exprime selon une formule du type :

$$FM = \frac{1}{1 + \left(M_{mod}^{opt} - 1\right) * \prod_k F_k(V_k)} \qquad\qquad (2)$$

où :

- $M_{mod}^{opt}$ est facteur optimal de réduction de mobilité, c'est-à-dire le rapport des perméabilités relatives au gaz ($k_{rg}$) et à la mousse $\left(k_{rg}^{FO}\right)$ dans des conditions optimales pour réduire la mobilité du gaz, c'est-à-dire les conditions dans lesquelles les termes $F_k(V_k)$ définis ci-dessous valent 1, soit :

$$M_{mod}^{opt} = \frac{k_{rg}\left(S_{g,opt}^{FO}\right)}{k_{rg}^{FO}\left(S_{g,opt}^{FO}\right)} = \frac{1}{FM_{opt}} \qquad\qquad (3)$$

- les termes $F_k(V_k)$ (avec k égal ou supérieur à 1) sont les valeurs des fonctions $F_k$ d'interpolation du facteur de réduction de mobilité entre la valeur $M_{mod}^{opt}$ et 1, qui dépendent chacune d'un paramètre $V_k$ relatif à au moins une caractéristique de la mousse, et qui font intervenir un certain nombre de constantes de calibration à calibrer comme expliqué ci-après.

Afin de fournir un modèle de déplacement de la mousse au simulateur représentatif de la réalité, le procédé selon l'invention vise à déterminer, de façon fiable à partir de mesures de déplacements représentatifs, les données de modélisation suivantes :

- le facteur de réduction de mobilité au gaz optimal $M_{\text{mod}}^{opt}$ tel que défini selon l'équation (3) ;
- les constantes de calibration de chacune des fonctions $F_k$ considérées dans la définition du modèle de déplacement de la mousse selon les équations (1) et (2).

Selon une mise en œuvre de l'invention, le paramètre $V_k$ peut être notamment la concentration en agent moussant $C_s^w$, la saturation en eau $S_w$, la saturation en huile $S_o$, ou encore le débit de gaz $u_g$.

Selon un mode de mise en œuvre de l'invention, la fonctionnelle de réduction de mobilité du gaz, notée *FM*, comporte quatre fonctions d'interpolation $F_k(V_k)$ et chacune de ces fonctions comporte deux constantes à calibrer à partir de données expérimentales. Selon un mode de mise en œuvre de l'invention dans lequel la fonctionnelle de réduction de mobilité du gaz comporte quatre fonctions d'interpolation $F_k(V_k)$, on définit :

- la fonction d'interpolation $F_1$ relative au paramètre $V_1 = C_s^w$ (concentration en agent moussant $C_s^w$ ) par une formule du type :

$$F_1 = \left( \frac{Min(C_s^w, C_s^{w-ref})}{C_s^{w-ref}} \right)^{e_s} \qquad (4)$$

et pour laquelle les constantes à calibrer sont l'exposant $e_s$, et la constante $C_s^{w-ref}$ qui correspond à la concentration en agent moussant dans des conditions optimales de référence ;
- la fonction d'interpolation $F_2$ relative au paramètre $V_2 = S_w$ (saturation en eau), par une formule du type :

$$F_2 = \left[ 0.5 + \frac{\arctan[f_w(S_w - S_w^*)]}{\pi} \right] \qquad (5)$$

et pour laquelle les constantes à déterminer sont la constante $f_w$ qui régit la transition (en fonction de la saturation en eau) entre les états moussant et non moussant et la constante $S_w^*$, qui représente la saturation en eau de transition entre états moussants stable et instable ;
- la fonction d'interpolation $F_3$ relative au paramètre $V_3 = S_o$ (saturation en huile) par une formule du type :

$$F_3 = \left( \frac{Max[0; S_o^* - S_o]}{S_o^*} \right)^{e_o} \qquad (6)$$

où $S_o^*$ est la saturation en huile au-delà de laquelle la mousse perd toutes ses facultés à réduire la mobilité du gaz, et l'exposant $e_o$ est une constante à déterminer ;
- la fonction d'interpolation $F_4$ relative au paramètre $V_4 = u_g$ (débit de gaz) par une formule du type :

$$F_4 = \left( \frac{N_c^*}{Max(N_c, N_c^*)} \right)^{e_c} \text{ avec } N_c = \frac{\mu_g u_g}{\phi \sigma_{wg}(C_s^w)} \qquad (7)$$

où $N_c^*$ est la valeur de référence du nombre capillaire $N_c$ calculée pour le débit optimal de référence. Les variables intervenant dans le calcul de $N_c$ sont la vitesse du gaz $u_g$, la porosité $\phi$ de la formation considérée, la tension interfaciale eau-gaz $\sigma_{gw}$ (qui est fonction de la concentration en agent moussant $C_s^w$ ), ainsi que la viscosité du

gaz $\mu_g$. L'exposant $e_c$ est également une constante à calibrer.

De façon générale, on peut montrer qu'une fonction quelconque d'interpolation $F_k$ du paramètre $V_k$ peut s'écrire sous la forme :

$$F_k(V_k) = \frac{\dfrac{1}{FM} - 1}{\dfrac{1}{FM_{opt}} - 1} = \frac{M_{\text{mod}}(V_k) - 1}{M_{\text{mod}}^{opt} - 1} \qquad (8)$$

où $M_{\text{mod}}(V_k)$ est la réduction de mobilité pour une valeur $V_k$ du paramètre k impactant la mousse (et pour des valeurs optimales des autres paramètres $V_j$, j étant différent de k) et où $M_{\text{mod}}^{opt} = M_{\text{mod}}(V_k^{opt})$ est la réduction de mobilité obtenue pour la valeur optimale $V_k^{opt}$ du paramètre $V_k$. Le procédé selon l'invention consiste ainsi, pour chaque paramètre $V_k$ impactant la mousse, à déterminer les facteurs $M_{\text{mod}}(V_k)$ pour diverses valeurs de ce paramètre, ainsi que $M_{\text{mod}}^{opt}$, puis à déterminer, à partir de ces facteurs, les constantes de la fonction d'interpolation $F_k$ considérée.

Selon un mode de mise en œuvre de l'invention dans lequel la fonctionnelle *FM* définie dans l'équation (2) fait intervenir les fonctions d'interpolation $F_1$, $F_2$, $F_3$ et $F_4$ définies aux équations (4) à (7), la détermination du modèle de déplacement de la mousse nécessite de calibrer les 8 constantes $C_s^{w-ref}$, $e_s$, $f_w$, $S_w^*$, $S_o^*$, $e_o$, $N_c^{ref}$, $e_c$.

Selon l'invention, la détermination des constantes des fonctions d'interpolation $F_k$ intervenant dans l'équation (2) est réalisée via une calibration fonction d'interpolation par fonction d'interpolation (et non pas globalement, pour l'ensemble des fonctions), à partir de mesures expérimentales relatives à chacune des fonctions d'interpolation, réalisées dans les conditions optimales établies pour les autres fonctions d'interpolation.

Le procédé selon l'invention comporte au moins les étapes suivantes, l'étape 1 pouvant être répétée pour chacune des fonctions d'interpolation du modèle de déplacement de la mousse :

### 1. Mesures en laboratoire relatives à une fonction d'interpolation

**1.1. Définition de valeurs du paramètre relatif à la fonction d'interpolation**
**1.2. Injections avec/sans mousse et mesures de pertes de charge**
**1.3. Détermination d'une valeur optimale de paramètre**

### 2. Mesures en laboratoire selon des conditions optimales
### 3. Détermination du modèle de déplacement de mousse

**3.1. Détermination du facteur de réduction de mobilité optimal**
**3.2. Calibration des constantes des fonctions d'interpolation**

### 4. Exploitation des hydrocarbures de la formation

Les différentes étapes du procédé selon l'invention sont détaillées ci-après.

### 1. Mesures en laboratoire relatives à une fonction d'interpolation

Au cours de cette étape, on réalise des expériences de laboratoire relatives à une fonction d'interpolation $F_k$ donnée du modèle de déplacement de la mousse défini selon les équations (1) et (2). Selon un mode de mise en œuvre de l'invention, cette étape est répétée pour chacune des fonctions d'interpolation intervenant dans le modèle de déplacement de la mousse défini selon les équations (1) et (2). A noter que le modèle de déplacement de la mousse peut toutefois ne comporter qu'une seule fonction d'interpolation (cas pour lequel k=1). Des valeurs optimales sont adoptées pour les autres paramètres impactant la mousse de telle sorte que les autres fonctions d'interpolation $F_j$, j différent de $k$, valent 1 ou soient invariantes lors de ces expériences relatives à la fonction d'interpolation $F_k$.

Au cours de cette étape, appliquée à chaque fonction d'interpolation indépendamment l'une de l'autre, on définit une pluralité de valeurs du paramètre relatif à la fonction d'interpolation considérée, puis on réalise une injection dans ledit échantillon du gaz sous forme non moussante et du gaz sous forme de mousse selon les valeurs du paramètre relatif à la fonction d'interpolation considérée, et on mesure respectivement une perte de charge avec mousse et une perte de charge sans mousse pour chacune des valeurs du paramètre relatif à cette fonction. Cette étape est détaillée ci-après pour une fonction d'interpolation $F_k$ donnée.

## 1.1. Définition de valeurs du paramètre relatif à la fonction d'interpolation

Au cours de cette sous-étape, il s'agit de définir une pluralité de valeurs $V_{k,i}$ (avec $i$ compris entre 1 et I, et I > 1) du paramètre caractéristique $V_k$ de la fonction d'interpolation $F_k$ considérée.

Selon un mode de mise en œuvre de l'invention, il s'agit de définir une gamme de valeurs de ce paramètre et un pas d'échantillonnage de cette gamme.

Selon un mode de mise en œuvre de l'invention, la pluralité de valeurs du paramètre $V_k$ relatif à la fonction d'interpolation $F_k$ considérée sont définies parmi les valeurs possibles ou réalistes du paramètre considéré (par exemple, une concentration massique d'agent moussant inférieure à 1% dans tous les cas) et de façon à échantillonner de façon ad hoc la courbe représentative de la fonction d'interpolation considérée (une fonction d'interpolation ayant un comportement linéaire n'a pas besoin d'un nombre élevé de mesures, contrairement à d'autres types de fonction). Le spécialiste en récupération assistée par injection de mousse a parfaite connaissance de la façon de définir une pluralité de valeurs ad hoc des paramètres de chacune des fonctions d'interpolation $F_k$.

Selon un mode de mise en œuvre de l'invention dans lequel la fonction d'interpolation considérée est relative au débit de fluide (paramètre $V_4$ de la fonction $F_4$ de l'équation (7)), on choisit par exemple un débit d'injection sur carotte compris entre 10 et 40 cm$^3$/h, avec un pas de 10 cm$^3$/h.

## 1.2. Injections avec/sans mousse et mesures de pertes de charge

Au cours de cette sous-étape, on réalise au moins deux séries d'expériences sur au moins un échantillon de la formation souterraine pour la fonction d'interpolation $F_k$ considérée :

- injection de gaz sous forme non moussante (plus précisément une co-injection d'eau et de gaz sous forme non moussante) dans l'échantillon considéré pour chacune des valeurs $V_{k,i}$ du paramètre $V_k$ relatif à la fonction $F_k$ considérée. Les débits de gaz et d'eau adoptés pour chacune de ces co-injections sont les mêmes que les débits de gaz et d'eau injectés sous forme de mousse dans les essais qui suivent ces co-injections. Par exemple, dans le cas de la fonction d'interpolation $F_4$ de l'équation (7), on fait uniquement varier le débit dans l'échantillon considéré, les paramètres des autres fonctions d'interpolation $F_1$, $F_2$, $F_3$ (par exemple, la concentration en agent moussant, la qualité de la mousse et la saturation en huile) étant fixés. Au cours de chacune des expériences de cette première série, on mesure une perte de charge (c'est-à-dire une différence de pression), que l'on note $\Delta P_{k,i}^{NOFO}$, pour chaque valeur $V_{k,i}$ ;

- injection de mousse : on répète la même expérience, pour les mêmes valeurs du paramètre considéré (par exemple le débit pour la fonction d'interpolation $F_4$ selon l'équation (7)), mais en injectant cette fois l'eau et le gaz sous forme de mousse. Au cours de chacune des expériences de cette deuxième série, on mesure une perte de charge (c'est-à-dire une différence de pression), que l'on note $\Delta P_{k,i}^{FO}$, pour chaque valeur $V_{k,i}$ ;

Selon un mode de mise en œuvre de l'invention, les injections de gaz sous forme non moussante et sous forme de mousse sont effectuées sur des échantillons de la formation initialement saturés d'une phase liquide (telle que de l'eau et/ou de l'huile), celle-ci pouvant être mobile ou résiduelle selon l'historique de la carotte et les objectifs de mesure (contrôle de mobilité du gaz en injection secondaire ou tertiaire, après injection d'eau). Les déplacements étudiés sont alors des processus de drainage dans lesquels la saturation de la phase gaz croît dans tous les cas.

Selon une variante de mise en œuvre de l'invention, on peut mesurer, en sus des pertes de charge, les productions de phase liquide (eau et/ou huile) et de gaz, et éventuellement, les profils de saturation en gaz durant la période transitoire du déplacement et dans l'état stationnaire. Ces mesures facultatives permettent de valider le modèle une fois les fonctions d'interpolation $F_k$ calibrées.

**1.3. Détermination d'une valeur optimale de paramètre**

Au cours de cette sous-étape, il s'agit de déterminer la valeur $V_k^{opt}$, que l'on nommera valeur optimale dans la suite, maximisant le rapport entre les pertes de charge sans mousse $\Delta P_{k,i}^{NOFO}$ et les pertes de charge avec mousse $\Delta P_{k,i}^{FO}$ relatives à la fonction d'interpolation $F_k$ considérée et mesurées au cours de la sous-étape précédente. Ainsi, si on note $M_{lab}^{k,i}$ le rapport des pertes de charge mesurées en présence et en l'absence de mousse pour la valeur $V_{k,i}$

$$M_{lab}^{k,i} = \frac{\Delta P_{k,i}^{FO}}{\Delta P_{k,i}^{NOFO}} = \frac{k_{rg}\left(S_{g(k,i)}^{NOFO}\right)}{k_{rg}^{FO}\left(S_{g(k,i)}^{FO}\right)}\ ,$$

du paramètre $V_k$, soit ⬆ on peut alors définir la valeur optimale $V_{k,iopt}$ comme la valeur $V_{k,i}$ qui maximise $M_{lab}^{k,i}$ dont la valeur est alors notée comme suit :

$$M_{lab}^{k,iopt} = M_{lab}^{kopt} = \underset{i}{Max}\, M_{lab}^{k,i} \qquad\qquad (9)$$

Selon un mode préféré de mise en œuvre de l'invention, l'étape 1 telle que décrite ci-dessus est répétée pour chacun des paramètres $V_k$ relatifs à chacune des fonctions d'interpolation $F_k$ prises en considération pour la mise en œuvre du procédé selon l'invention. Ainsi à l'issue d'une telle répétition, on obtient une valeur optimale $V_k^{opt}$ pour chaque paramètre $V_k$.

Par la suite, on appelle « conditions optimales » l'ensemble des valeurs $V_k^{opt}$ déterminées à l'issue de l'étape 1, celle-ci étant le cas échéant répétée pour chacune des fonctions d'interpolation prises en considération pour la mise en œuvre du procédé selon l'invention.

**2. Mesures en laboratoire selon des conditions optimales**

Au cours de cette étape, il s'agit de réaliser deux types d'expériences sur au moins un échantillon de la formation souterraine, en injectant du gaz sous forme non moussante, et du gaz sous forme de mousse, similairement à la sous-étape 1.2, mais cette fois dans les conditions optimales déterminées à l'issue de la sous-étape 1.3, cette sous-étape étant répétée le cas échéant pour chacune des fonctions d'interpolation prises en considération pour la définition du modèle de déplacement de la mousse selon les équations (1) et (2)). Autrement dit, on réalise les mesures suivantes :

- injection de gaz sous forme non moussante (plus précisément une co-injection d'eau et de gaz sous forme non moussante) dans l'échantillon considéré, cette injection étant réalisée dans les conditions optimales (définies par l'ensemble des valeurs optimales $V_k^{opt}$ déterminées pour chaque paramètre $V_k$) déterminées à l'issue de l'étape 1. Au cours de cette première expérience, on mesure une perte de charge (c'est-à-dire une différence de pression), que l'on note $\Delta P_{opt}^{NOFO}$ par la suite ;

- injection de mousse (c'est-à-dire une injection de gaz et d'eau, avec une adjonction d'un agent moussant dans l'une des phases eau ou gaz) dans l'échantillon considéré, cette injection étant réalisée dans les conditions optimales (définies par l'ensemble des valeurs optimales $V_k^{opt}$ déterminées pour chaque paramètre $V_k$) déterminées à l'issue de l'étape 1. Au cours de cette deuxième expérience, on mesure une perte de charge (c'est-à-dire une différence de pression), que l'on note $\Delta P_{opt}^{FO}$ par la suite.

Par la suite, on notera $M_{lab}^{opt}$ le facteur de réduction de mobilité optimal relatif aux mesures de laboratoire, défini par une formule du type :

$$M_{lab}^{opt} = \frac{\Delta P_{opt}^{FO}}{\Delta P_{opt}^{NOFO}} = \frac{k_{rg}\left(S_{g,opt}^{NOFO}\right)}{k_{rg}^{FO}\left(S_{g,opt}^{FO}\right)} \qquad (10).$$

Cette étape n'est pas nécessaire en pratique si on a bien pris la précaution de réaliser les expériences de l'étape 1 relatives à chacun des paramètres $V_k$ en adoptant des valeurs optimales $V_{j,j\neq k}^{opt}$ des autres paramètres $V_j$ impactant la mousse. Cette étape permet néanmoins d'affiner la valeur de $M_{lab}^{opt}$ si les conditions supposées optimales des paramètres $V_{j,j\neq k}$ n'étaient pas tout à fait satisfaites.

**3. Détermination du modèle de déplacement de mousse**

**3.1. Détermination du facteur de réduction de mobilité optimal**

Au cours de cette sous-étape, il s'agit, à partir des mesures de perte de charge réalisées dans les conditions optimales, de mesures de perméabilités relatives conventionnelles au gaz sous forme non moussante et de mesures de perméabilités relatives conventionnelles à la phase aqueuse, de déterminer un facteur de réduction de mobilité optimal, c'est-à-dire le facteur de réduction des perméabilités relatives au gaz lorsque, présent à une saturation donnée au sein du milieu poreux, il circule sous forme de mousse ou sous forme de phase continue (en présence d'eau).
Selon un mode de mise en œuvre de l'invention, on détermine le facteur de réduction de mobilité optimal selon au moins les étapes suivantes :

- à partir des perméabilités relatives conventionnelles au gaz $k_{rg}$ et à la phase aqueuse $k_{rw}$, on calcule la saturation en gaz en régime permanent d'écoulement de gaz et d'eau non moussante $S_g^{NOFO}$ selon une formule du type :

$$\boxed{S_g^{NOFO} = \left(\frac{k_{rg}}{k_{rw}}\right)^{-1}\left(\frac{f_g}{1-f_g}\frac{\mu_g}{\mu_w}\right)} \qquad (11)$$

où $f_g$ est le débit fractionnaire de gaz (rapport du débit de gaz au débit total), $\mu_g$ et $\mu_w$ sont respectivement la viscosité du gaz et de l'eau ;
- à partir du rapport de pertes de charge mesurées dans les conditions optimales telles que définies à l'issue de l'étape 1 (l'étape 1 pouvant être répétée le cas échéant pour chacune des fonctions d'interpolation $F_k$ considérées), de la saturation en gaz en régime permanent d'écoulement de gaz et d'eau non moussante $S_g^{NOFO}$, on calcule la saturation en gaz en présence de mousse $S_g^{FO}$ selon une formule du type :

$$\boxed{S_{g,opt}^{FO} = 1 - \left(k_{rw}\right)^{-1}\left\{\frac{k_{rw}(S_w^{NOFO}=1-S_g^{NOFO})}{M_{lab}^{opt}}\right\}} \qquad (12)$$

Cette relation découle de l'hypothèse connue d'invariance des fonctions de perméabilité relative à l'eau s'écoulant sous forme de films de mousse ou sous forme continue classique.
- à partir de la saturation en gaz en régime permanent d'écoulement de gaz et d'eau non moussante $S_g^{NOFO}$, de la saturation en gaz en présence de mousse $S_{g,opt}^{FO}$ dans les conditions optimales, du facteur $M_{lab}^{opt}$ déterminé dans les conditions optimales (cf étape 2), on détermine le facteur de réduction de mobilité $M_{\text{mod}}^{opt}$ selon une formule du type :

$$M_{\text{mod}}^{opt} = M_{lab}^{opt} \frac{k_{rg}\left(S_{g,opt}^{FO}\right)}{k_{rg}\left(S_{g,opt}^{NOFO}\right)} \qquad (13)$$

### 3.2. Calibration des constantes des fonctions d'interpolation

Au cours de cette sous-étape, on calibre les constantes de chacune des fonctions d'interpolation $F_k$ considérées, à partir du facteur de réduction de mobilité optimal $M_{\text{mod}}^{opt}$, des mesures de perte de charge relatives à la fonction d'interpolation considérée, des mesures de perméabilités relatives conventionnelles au gaz sous forme non moussante et des mesures de perméabilités relatives conventionnelles à la phase aqueuse.

Selon un mode de mise en œuvre de l'invention, on applique préalablement la procédure décrite à la sous-étape 3.1 aux rapports des pertes de charge $M_{lab}^{k,i}$ mesurées en présence et en l'absence de mousse pour les différentes valeurs $V_{k,i}$ du paramètre $V_k$. Ainsi, on détermine des facteurs de réduction de mobilité $M_{\text{mod}}^{k,i}$ relatifs aux valeurs $V_{k,i}$ du paramètre $V_k$ selon une formule du type :

$$M_{\text{mod}}^{k,i} = M_{lab}^{k,i} \frac{k_{rg}\left(S_{g(k,i)}^{FO}\right)}{k_{rg}\left(S_{g(k,i)}^{NOFO}\right)} \qquad (14),$$

où la saturation en gaz en présence de mousse $S_{g(k,i)}^{FO}$ pour la valeurs $V_{k,i}$ du paramètre $V_k$ est obtenue selon une formule du type :

$$\boxed{S_{g(k,i)}^{FO} = 1 - \left(k_{rw}\right)^{-1}\left\{\frac{k_{rw}\left(S_{w(k,i)}^{NOFO} = 1 - S_{g(k,i)}^{NOFO}\right)}{M_{lab}^{k,i}}\right\}} \qquad (15)$$

Avantageusement, cette opération est répétée pour chacune des fonctions d'interpolation $F_k$. Puis on calibre les constantes de chacune des fonctions d'interpolation $F_k$ considérées, à partir du facteur de réduction de mobilité optimal $M_{\text{mod}}^{opt}$ et des valeurs des facteurs de réduction de mobilité $M_{\text{mod}}^{k,i}$ relatifs à chaque fonction d'interpolation déterminés tel que décrit ci-dessus. Dans le cas de la fonction $F_4$ par exemple, on détermine une valeur de l'exposant $e_c$ qui ajuste au plus près les valeurs de $M_{\text{mod}}^{4,i}$ correspondant aux valeurs $V_{4,i}$ du paramètre étudié (débit dans cet exemple), ce qui se formule comme suit :

$$F_4(V_{4,i}) = \left(\frac{N_c^*}{Max(N_{c,i}, N_c^*)}\right)^{e_c} = \frac{M_{\text{mod}}^{4,i} - 1}{M_{\text{mod}}^{opt} - 1}$$

Selon un mode de mise en œuvre de l'invention, cette calibration, fonction d'interpolation par fonction d'interpolation, peut s'effectuer par une méthode des moindres carrés, comme par exemple une méthode inverse basée sur la minimisation itérative d'une fonctionnelle. Le spécialiste a parfaite connaissance de telles méthodes. Avantageusement, la mise en œuvre d'une méthode des moindres carrés, et en particulier la minimisation itérative d'une fonctionnelle, est réalisée au moyen d'un ordinateur.

Selon un autre mode de mise en œuvre de l'invention, on procède à une telle calibration, fonction d'interpolation par fonction d'interpolation, de manière graphique. Le spécialiste a parfaite connaissance de telles méthodes de calibration de constantes d'une fonction à partir d'une série de valeurs de ladite fonction.

Ainsi, à l'issue de cette étape, on dispose d'un modèle de déplacement de la mousse calibré et apte à être utilisé par un simulateur d'écoulement ad hoc.

## 4. Exploitation des hydrocarbures

Au cours de cette étape, il s'agit de définir au moins un schéma d'exploitation optimal du fluide contenu dans la formation, c'est-à-dire un schéma d'exploitation permettant une exploitation optimale d'un fluide considéré suivant des critères technico-économiques prédéfinis par le spécialiste. Il peut s'agir d'un scénario offrant un fort taux de récupération du fluide, sur une longue durée d'exploitation, et nécessitant un nombre de puits limité. Puis, selon l'invention, on exploite le fluide de la formation étudiée en fonction de ce schéma d'exploitation optimal.

Selon l'invention, la détermination dudit schéma d'exploitation est réalisée à l'aide d'une simulation d'écoulement exploitant le modèle de déplacement de la mousse établi au cours des étapes précédentes. Un exemple de simulateur d'écoulement permettant la prise en compte d'un modèle de déplacement de la mousse est le logiciel PumaFlow (IFP Energies nouvelles, France).

Selon l'invention, à tout instant t de la simulation, le simulateur d'écoulement résout l'ensemble des équations d'écoulement propres à chaque maille et délivre des valeurs solutions des inconnues (saturations, pressions, concentrations, température,...) prédites à cet instant t. De cette résolution, découle la connaissance des quantités d'huile produites et de l'état du gisement (distribution des pressions, saturations, etc...) à l'instant considéré. Selon un mode de mise en œuvre de l'invention, on définit différents schémas d'exploitation du fluide de la formation étudiée et on estime, à l'aide du simulateur d'écoulement intégrant le modèle de déplacement de la mousse déterminé à l'issue de l'étape 3, la quantité d'hydrocarbures produit selon chacun des différents schémas d'exploitation.

Un schéma d'exploitation relatif à une récupération assistée par injection de mousse peut notamment être défini par un type de gaz injecté dans la formation étudiée et/ou par le type d'agent moussant adjoint à ce gaz, par la quantité d'agent moussant etc. Un schéma d'exploitation est également défini par un nombre, une géométrie et une implantation (position et espacement) des puits injecteurs et producteurs afin de tenir compte au mieux de l'impact des fractures sur la progression des fluides au sein du réservoir. Afin de définir un schéma d'exploitation optimal, différents essais de différents scenarii de production peuvent être réalisés à l'aide d'un simulateur d'écoulement. Le schéma d'exploitation offrant le meilleur taux de récupération de fluide pour un coût le plus faible sera par exemple préféré. En sélectionnant divers scénarios, caractérisés par exemple par diverses implantations respectives des puits injecteurs et producteurs, et en simulant la production de fluide pour chacun d'eux, on peut sélectionner le scénario permettant d'optimiser la production de la formation considérée suivant des critères technico-économiques prédéfinis par le spécialiste. Le schéma d'exploitation offrant le meilleur taux de récupération de fluide pour un coût le plus faible sera par exemple considéré comme le schéma d'exploitation optimal.

Les spécialistes exploitent alors le fluide de la formation considérée selon le scénario permettant d'optimiser la production du gisement, notamment en forant les puits injecteurs et producteurs définis par ledit schéma d'exploitation optimal, et à produire le fluide selon le procédé de récupération défini par ledit schéma d'exploitation optimal.

## Exemple de réalisation

Les caractéristiques et avantages du procédé selon l'invention apparaîtront plus clairement à la lecture de l'exemple d'application ci-après.

Plus précisément, la présente invention a été appliquée à une formation souterraine dont la roche réservoir est constituée de grès du type grès de Berea. Une récupération assistée des hydrocarbures contenus dans le réservoir à base d'une injection de $CO_2$ moussant est expérimentée.

Pour cet exemple, on utilise une fonctionnelle *FM* du modèle de déplacement de la mousse selon l'équation (2) définie par les quatre fonctions d'interpolation selon les équations (4) à (7). Comme prescrit dans le procédé selon l'invention, la calibration des constantes des fonctions d'interpolation est réalisée fonction d'interpolation par fonction d'interpolation. Seule la calibration de la fonction d'interpolation $F_4$ (cf équation (7)) est détaillée ci-après, mais le même principe peut être appliqué aux autres fonctions d'interpolation.

Conformément à l'étape 1.2 décrite ci-dessus, une série de co-injections de gaz et d'eau et d'injections de mousse ont été réalisées en laboratoire, sur un échantillon de la roche réservoir provenant de la formation étudiée. Les caractéristiques de cet échantillon ainsi que les conditions de mesure sont présentées dans le Tableau 1. Un mélange gazeux peu dense constitué de 62 % de $CO_2$ et 38 % de méthane à une température de 100°C et une pression de 100 bars a été injecté. Ces déplacements ont été effectués avec un débit fractionnaire de gaz fixé (égal à 0.8) et pour différents débits totaux successifs (10, 20, 30 et 40 $cm^3$/h). L'huile est absente pour cette série d'essais et les pertes de charge en régime permanent d'écoulement d'eau et de gaz d'une part, de mousse d'autre part, ont été mesurées dans les mêmes conditions.

Les perméabilités relatives conventionnelles requises pour la résolution des équations (11) et (12) sont des fonctions analytiques définies comme des fonctions puissances (dites de Corey) d'exposants égaux à environ 2.5 pour le gaz et 3.9 pour l'eau avec une saturation irréductible en eau en drainage égale à 0.15, et des points-limites égaux à 0.2 pour le gaz et 1 pour l'eau, soit :

$$k_{rg}(S_g^{NOFO}) = 0.2 \left( \frac{S_g^{NOFO}}{0.85} \right)^{2.5}$$

$$k_{rw}(S_w^{NOFO}) = \left( \frac{S_w^{NOFO} - 0.15}{0.85} \right)^{3.9}$$

Ces courbes de perméabilités relatives ont été estimées a priori à partir de données de la littérature et vérifiées a posteriori par comparaison des valeurs de perte de charge calculées et mesurées lors des co-injections de gaz et d'eau. De cette manière, le modèle de perméabilité relative à la mousse restitue bien les réductions de mobilité du gaz, *i.e.* les rapports de perméabilité relative en l'absence et en présence de mousse, sans toutefois nécessairement bien reproduire le comportement diphasique réel (états transitoires notamment).

Le Tableau 1 présente les pertes de charge (gradient de pression) avec et sans mousse pour quatre valeurs du paramètre $V_4 = u_g$ de l'équation (7). A partir de ces valeurs, on en déduit la valeur de $M_{lab}^{kopt} = \underset{i}{Max}\, M_{lab}^{k,i}$. Cette valeur ( $M_{lab}^{4opt}$ dans cet exemple), égale à 83, a été obtenue pour un débit $V_4^{opt}$ égal à 20 cm³/h (cf sous-étape 1.3). Ces expériences de laboratoire sont répétées pour les autres paramètres des autres fonctions d'interpolation $F_1$, $F_2$, et $F_3$. On détermine alors les conditions optimales pour l'ensemble des fonctions d'interpolation.

Conformément à l'étape 2, on réalise des mesures avec et sans mousse dans les conditions optimales ainsi déterminées. On détermine ensuite, conformément à l'étape 3.1, le facteur de réduction de mobilité optimal $M_{mod}^{opt}$ ainsi que les valeurs des facteurs de réduction de mobilité $M_{mod}^{k,i}$ relatifs aux valeurs échantillonnées $V_{k,i}$ du paramètre $V_k$, conformément à l'étape 3.2. On procède ensuite à la calibration de chacune des fonctions d'interpolation. En particulier, la constante $e_c$ de la fonction $F_4$ a été calibrée et une valeur voisine de 0.6 a été déterminée.

La Figure 1 présente en trait plein l'évolution du facteur de réduction de mobilité R en fonction du paramètre $V_4$ de la fonction $F_4$ (débit Q) déduit du procédé selon l'invention. La comparaison avec le facteur de réduction de mobilité issu de la simulation d'écoulement (courbe en trait pointillé) montre une bonne cohérence avec le modèle de déplacement de la mousse selon l'invention.

Ainsi le procédé selon l'invention permet une détermination fiable du modèle de déplacement de la mousse à partir de données expérimentales réalisées et traitées selon une approche séquentielle et systématique, paramètre par paramètre, et non par l'ajustement global d'un ensemble de mesures faisant varier un ou plusieurs paramètres simultanément. Par ailleurs, compte tenu de la complexité paramétrique du comportement des mousses, les expériences selon le procédé selon l'invention sont réalisées dans des conditions les plus proches possible des conditions de réservoir.

Tableau 1

| Grés de Berea | Débit total [cm3/h] | 10 | 20 | 30 | 40 |
|---|---|---|---|---|---|
| P = 100 bar<br>T = 100°C | $\Delta P_{k,i}^{FO}$ | 5,2 | 10,3 | 11,9 | 13,6 |
| L = 15 cm | $\Delta P_{k,i}^{NOFO}$ | 0,07 | 0,124 | 0,18 | 0,235 |
| A = 12,56 cm2<br>Φ=0,19<br>Kw=120mD<br>μw=0,28cp<br>μg=0,02cp<br>ρg=0,125g/cm3 | $M_{lab}^{k,i} = \dfrac{\Delta P_{k,i}^{NOFO}}{\Delta P_{k,i}^{FO}}$ | 74 | 83 | 66 | 58 |

**Revendications**

1. Procédé d'exploitation d'une formation souterraine comportant des hydrocarbures, au moyen d'une injection d'une solution aqueuse comprenant un gaz sous forme de mousse et d'un simulateur d'écoulement reposant sur un modèle de déplacement dudit gaz sous forme de mousse, ledit modèle de déplacement étant fonction d'un facteur de réduction de mobilité dudit gaz optimal et d'au moins une fonction d'interpolation dudit facteur de réduction de mobilité optimal, ladite fonction d'interpolation étant fonction d'au moins un paramètre relatif à au moins une caractéristique de la mousse et d'au moins une constante, **caractérisé en ce que**, à partir d'au moins un échantillon de ladite formation, de mesures de perméabilités relatives conventionnelles audit gaz sous forme non moussante et de mesures de perméabilités relatives conventionnelles à ladite phase aqueuse :

   A. on détermine ledit modèle de déplacement dudit simulateur selon au moins les étapes suivantes :

      i. on définit une pluralité de valeurs dudit paramètre relatif à au moins une desdites fonctions d'interpolation, on réalise une injection dans ledit échantillon dudit gaz sous forme non moussante et dudit gaz sous forme de mousse selon lesdites valeurs dudit paramètre relatif à ladite fonction, et on mesure respectivement une perte de charge avec mousse et une perte de charge sans mousse pour chacune desdites valeurs dudit paramètre relatif à ladite fonction ;
      ii. à partir desdites mesures de perte de charge relatives à ladite fonction d'interpolation, on détermine une valeur optimale dudit paramètre relatif à ladite fonction, ladite valeur optimale permettant de maximiser un rapport entre lesdites pertes de charge sans mousse et lesdites pertes de charge avec mousse mesurées pour ladite fonction ;
      iii. on définit des conditions optimales comme correspondant auxdites valeurs optimales déterminées pour chacune desdites fonctions d'interpolation, on injecte dans ledit échantillon ledit gaz sous forme non moussante et ledit gaz sous forme de mousse selon lesdites conditions optimales, et on mesure respectivement une perte de charge avec mousse et une perte de charge sans mousse ;
      iv. à partir desdites mesures de perte de charge réalisées pour lesdites conditions optimales, desdites mesures de perméabilités relatives conventionnelles audit gaz sous forme non moussante et desdites mesures de perméabilités relatives conventionnelles à ladite phase aqueuse, on détermine ledit facteur de réduction de mobilité optimal ;
      v. pour au moins ladite fonction d'interpolation, à partir dudit facteur de réduction de mobilité optimal, desdites mesures de perte de charge relatives à ladite fonction d'interpolation, desdites mesures de perméabilités relatives conventionnelles audit gaz sous forme non moussante et desdites mesures de perméabilités relatives conventionnelles à ladite phase aqueuse, on calibre lesdites constantes de ladite fonction d'interpolation ;

   B- à partir dudit modèle de déplacement et dudit simulateur d'écoulement, on détermine un schéma d'exploitation optimal dudit gisement et on exploite lesdits hydrocarbures.

2. Procédé selon la revendication 1, dans lequel ledit modèle de déplacement de la mousse s'exprime sous la forme :

$$k_{rg}^{FO}(S_g) = FM\, k_{rg}(S_g)$$

où $k_{rg}^{FO}(S_g)$ est la perméabilité relative audit gaz sous forme de mousse pour une valeur de saturation en gaz $S_g$ donnée, $k_{rg}(S_g)$ est la perméabilité relative audit gaz non moussant pour ladite valeur de saturation en gaz $S_g$, et $FM$ est une fonctionnelle s'exprimant sous la forme :

$$FM = \frac{1}{1 + \left(M^{opt} - 1\right) * \prod_k F_k}$$

où $M^{opt}$ est ledit facteur de réduction de mobilité dudit gaz optimal et $F_k$ est une desdites fonctions d'interpolation, avec k≥1.

3. Procédé selon l'une des revendications précédentes, dans lequel lesdites fonctions d'interpolation sont au nombre de quatre et lesdits paramètres desdites fonctions sont une concentration en agent moussant, une saturation en eau, une saturation en huile, et un débit de gaz.

4. Procédé selon l'une des revendications précédentes, dans lequel ladite fonction d'interpolation $F_k$ d'un paramètre $V_k$ s'écrit sous la forme :

$$F_k(V_k) = \frac{M_k^{opt} - 1}{M^{opt} - 1}$$

où $M^{opt}$ est ledit facteur de réduction de mobilité optimal et $M_k^{opt}$ est un facteur de réduction de mobilité optimal pour ledit paramètre $V_k$.

5. Procédé selon l'une des revendications précédentes, dans lequel on calibre lesdites constantes d'au moins une desdites fonctions d'interpolation par une méthode des moindres carrés, telle qu'une méthode inverse basée sur la minimisation itérative d'une fonctionnelle.

**Patentansprüche**

1. Verfahren zur Nutzung einer unterirdischen Formation, die Kohlenwasserstoffe umfasst, mit Hilfe einer Injektion einer wässrigen Lösung, die ein Gas in der Form eines Schaums umfasst, und eines Strömungssimulators, der auf einem Verdrängungsmodell des Gases in der Form eines Schaums beruht, wobei das Verdrängungsmodell eine Funktion eines optimalen Mobilitätsreduktionsfaktors des Gases und mindestens einer Interpolationsfunktion des optimalen Mobilitätsreduktionsfaktors ist, wobei die Interpolationsfunktion eine Funktion mindestens eines Parameters in Bezug auf eine Charakteristik des Schaums und mindestens einer Konstante ist, **dadurch gekennzeichnet, dass**, mindestens aus einer Probe der Formation, herkömmlichen Permeabilitätsmessungen in Bezug auf das Gas in nicht schäumender Form und herkömmlichen Permeabilitätsmessungen in Bezug auf die wässrige Phase:

A. das Verdrängungsmodell des Simulators gemäß mindestens einem der folgenden Schritte bestimmt wird:

i. eine Vielzahl von Werten des Parameters in Bezug auf mindestens eine der Interpolationsfunktionen wird definiert, eine Injektion des Gases in nicht schäumender Form und des Gases in der Form eines Schaums in die Probe wird gemäß den Werten des Parametes in Bezug auf die Funktion durchgeführt, und es werden jeweils ein Ladungsverlust mit Schaum und ein Ladungsverlust ohne Schaum für jeden der Werte des Parameters in Bezug auf die Funktion gemessen;

ii. aus den Messungen des Ladungsverlusts in Bezug auf die Interpolationsfunktion wird ein optimaler Wert des Parameters in Bezug auf die Funktion bestimmt, wobei es der optimale Wert gestattet, ein Verhältnis zwischen den Ladungsverlusten ohne Schaum und den Ladungsverlusten mit Schaum zu maximieren, die für die Funktion gemessen wurden;

iii. die optimalen Bedingungen werden als den optimalen Werten entsprechend definiert, die für jede der Interpolationsfunktionen bestimmt wurden, in die Probe werden das Gas in nicht schäumender Form und das Gas in der Form eines Schaums gemäß den optimalen Bedingungen injiziert, und es werden jeweils ein Ladungsverlust mit Schaum und ein Ladungsverlust ohne Schaum gemessen;

iv. aus den Messungen des Ladungsverlusts, die für die optimalen Bedingungen durchgeführt wurden, den herkömmlichen Permeabilitätsmessungen in Bezug auf das Gas in nicht schäumender Form und den herkömmlichen Permeabilitätsmessungen in Bezug auf die wässrige Phase wird der optimale Mobilitätsreduktionsfaktor bestimmt;

v. für mindestens die Interpolationsfunktion werden, aus dem optimalen Mobilitätsreduktionsfaktor, den Messungen des Ladungsverlusts in Bezug auf die Interpolationsfunktion, den herkömmlichen Permeabilitätsmessungen in Bezug auf das Gas in nicht schäumender Form und den herkömmlichen Permeabilitätsmessungen in Bezug auf die wässrige Phase, die Konstanten der Interpolationsfunktion kalibriert;

B. aus dem Verdrängungsmodell und dem Strömungssimulator wird ein optimales Nutzungsschema der Lagerstätte bestimmt, und die Kohlenwasserstoffe werden genutzt.

2. Verfahren nach Anspruch 1, wobei das Verdrängungsmodell des Schaums ausgedrückt wird in der Form:

$$k_{rg}^{FO}\left(S_g\right) = FM\, k_{rg}\left(S_g\right)$$

wobei $k_{rg}^{FO}(S_g)$ die Permeabilität in Bezug auf das Gas in der Form eines Schaums für einen gegebenen Gassättigungswert $S_g$ ist, $k_{rg}(S_g)$ die Permeabilität in Bezug auf das nicht schäumende Gas für den Gassättigungswert $S_g$ ist, und FM ein Funktional ist, das ausgedrückt wird in der Form:

$$FM = \frac{1}{1 + (M^{opt}) * \prod_k F_k}$$

wobei $M^{opt}$ der optimale Mobilitätsreduktionsfaktor des Gases ist, und $F_k$ eine der Interpolationsfunktionen ist, wobei $k \geq 1$.

3. Verfahren nach einem der vorhergehenden Ansprüche, wobei die Interpolationsfunktionen vier an der Zahl sind, und die Parameter der Funktionen eine Konzentration an Schaummittel, eine Sättigung an Wasser, eine Sättigung an Öl und ein Gasdurchsatz sind.

4. Verfahren nach einem der vorhergehenden Ansprüche, wobei die Interpolationsfunktion $F_k$ eines Parameters $V_k$ in der Form geschrieben wird:

$$F_k\left(V_k\right) = \frac{M_k^{opt} - 1}{M^{opt} - 1}$$

wobei $M^{opt}$ der optimale Mobilitätsreduktionsfaktor ist, und $M_k^{opt}$ ein optimaler Mobilitätsreduktionsfaktor für den Parameter $V_k$ ist.

5. Verfahren nach einem der vorhergehenden Ansprüche, wobei die Konstanten mindestens einer der Interpolationsfunktionen durch eine Methode der kleinsten Quadrate bestimmt wird, wie eine inverse Methode, die auf der iterativen Minimierung eines Funktionals basiert.

**Claims**

1. Method for operating an underground formation comprising hydrocarbons, by means of an injection of an aqueous solution comprising a gas in foam form and a flow simulator relying on a displacement model of said gas in foam form, said displacement model being a function of an optimal mobility reduction factor of said gas and of at least one interpolation function of said optimal mobility reduction factor, said interpolation function being a function of at least one parameter relating to at least one characteristic of the foam and of at least one constant, **characterized in that**, from at least one sample of said formation, measurements of conventional relative permeabilities to said gas in non-foaming form and measurements of conventional relative permeabilities to said aqueous phase:

   A. said displacement model of said simulator is determined according to at least the following steps:

   i. a plurality of values of said parameter is defined relative to at least one of said interpolation functions, an injection is performed into said sample of said gas in non-foaming form and of said gas in foam form according to said values of said parameter relative to said function, and a headloss with foam and a headloss without foam are measured respectively for each of said values of said parameter relative to said function;
   ii. from said measurements of headloss relative to said interpolation function, an optimal value of said parameter relative to said function is determined, said optimal value making it possible to maximize a ratio between said headlosses without foam and said headlosses with foam measured for said function;

iii. optimal conditions are defined as corresponding to said optimal values determined for each of said interpolation functions, said gas in non-foaming form and said gas in foam form are injected into said sample according to said optimal conditions, and a headloss with foam and a headloss without foam are respectively measured.

iv. from said measurements of headloss performed for said optimal conditions, from said measurements of conventional relative permeabilities to said gas in non-foaming form and from said measurements of conventional relative permeabilities to said aqueous phase, said optimal mobility reduction factor is determined;

v. for at least said interpolation function, from said optimal mobility reduction factor, from said measurements of headloss relative to said interpolation function, from said measurements of conventional relative permeabilities to said gas in non-foaming form and from said measurements of conventional relative permeabilities to said aqueous phase, said constants of said interpolation function are calibrated;

B- from said displacement model and from said flow simulator, an optimal operation scheme for said deposit is determined and said hydrocarbons are exploited.

2. Method according to Claim 1, in which said displacement model of the foam is expressed in the form:

$$k_{rg}^{FO}(S_g) = FM \, k_{rg}(S_g)$$

in which $k_{rg}^{FO}(S_g)$ is the relative permeability to said gas in foam form for a given gas saturation value $S_g$, $k_{rg}(S_g)$ is the relative permeability to said non-foaming gas for said gas saturation value $S_g$, and $FM$ is a functional expressed in the form:

$$FM = \frac{1}{1 + \left(M^{opt} - 1\right) * \prod_k F_k}$$

in which $M^{opt}$ is said optimal mobility reduction factor of said gas and $F_k$ is one of said interpolation functions, with $k \geq 1$.

3. Method according to one of the preceding claims, in which there are four of said interpolation functions and said parameters of said functions are a foaming agent concentration, a water saturation, an oil saturation and a gas flow rate.

4. Method according to one of the preceding claims, in which said interpolation function $F_k$ of a parameter $V_k$ is written in the form:

$$F_k(V_k) = \frac{M_k^{opt} - 1}{M^{opt} - 1}$$

in which $M^{opt}$ is said optimal mobility reduction factor and $M_k^{opt}$ is an optimal mobility reduction factor for said parameter $V_k$.

5. Method according to one of the preceding claims, in which said constants of at least one of said interpolation functions are calibrated by a least squares method, such as an inverse method based on the iterative minimization of a functional.

**Fig. 1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- Estimation of Parameters for the Simulation of Foam Flow through Porous Media. **MA, K. ; LOPEZ-SALINAS, J.L. ; PUERTO, M.C. ; MILLER, C.A. ; BISWAL, S.L. ; HIRASAKI, G.J.** The Dry-Out Effect. Energy & Fuels. ACS, 2013, vol. 27, 2363-2375
- Effect of Permeability on Implicit-Texture Foam Model Parameters and the Limiting Capillary Pressure. **FARAJZADEH, R. ; LOTFOLLAHI, M. ; EFTEKHARI, A.A. ; ROSSEN, W.R. ; HIRASAKI, G.J.** Energy Fuels. ACS, 2015, vol. 29, 3011-3018

- Effect of Permeability on Foam-Model Parameters - An Integrated Approach from Coreflood Experiments through to Foam Diversion Calculations. **KAPETAS, L. ; VINCENT-BONNIEU, S. ; FARAJZADEH, R. ; EFTEKHARI, A.A. ; MOHD-SHAFIAN, S.R. ; KAMARUL BAHRIM, R.Z. ; ROSSEN, W.R.** 18th European Symposium. IOR, 14 Avril 2015
- **ZENG ; YONGCHAO ; MUTHUSWAMY ; AARTHI ; MA ; KUN et al.** Insights on Foam Transport from a Texture-Implicit Local-Equilibrium Model with an Improved Parameter Estimation Algorithm. *Industrial & Engineering Chemistry Research,* 2016, vol. 55 (28), 7819-7829, http://dx.doi.org/10.1021/acs.iecr.6b01424